# EUROPEAN PATENT APPLICATION

(11) **EP 4 451 134 A1**
(43) Date of publication of application: **23.10.2024**
(21) Application number: 22922649.3
(22) Date of filing: 26.01.2022
(51) Int. Cl.: G06F 13/40, G06F 18/00

(54) **DATA BUS INVERSION JUDGMENT METHOD, CIRCUIT AND DEVICE**

(71) Applicant: Huawei Technologies Co., Ltd., Shenzhen, Guangdong 518129 (CN)
(72) Inventor: PARK, Sanghyun, Shenzhen, Guangdong 518129 (CN); LIU, Rongbin, Shenzhen, Guangdong 518129 (CN); YIN, Shihui, Shenzhen, Guangdong 518129 (CN)
(74) Representative: Goddar, Heinz J.
(86) International application number: PCT/CN2022/073936
(87) International publication number: WO 2023/141798

(57) **Abstract**

Embodiments of this application provide a data bus inversion determining method, a circuit, and a device. The method includes: receiving N first input signals, where N is a positive integer; obtaining N first voltage signals based on the N first input signals, where the N first voltage signals are in one-to-one correspondence with the N first input signals; determining an average voltage value of the N first voltage signals; and determining, based on the average voltage value, whether to invert N second input signals, where the N first input signals are the same as the N second input signals, or the N first input signals are obtained based on the N second input signals. According to the method, the circuit, and the device in embodiments of this application, an average voltage value of N voltage signals is determined, and a determining result is used to determine whether to perform inversion and outputting. This avoids use of a large quantity of adder circuits and logic circuits, and greatly reduces an area, latency, and power consumption of the circuit.

## Description

### TECHNICAL FIELD

Embodiments of this application relate to the field of electronic technologies, and in particular, to a data bus inversion determining method, a circuit, and an electronic device.

### BACKGROUND

Currently, a data bus inversion (Data Bus Inversion, DBI) function is widely applied to the field of dynamic random access memories (Dynamic Random Access Memories, DRAMs). The DBI function is to collect statistics on input data, and determine whether more than half of the input data is a low voltage. If more than half of the data is a low voltage, an output DBI signal is a high voltage, and the input data is inverted and output. If not more than half of the data is a low voltage, the output DBI signal is a low voltage, and the input data is directly output.

To implement the DBI function, a DBI circuit is proposed in the industry. In the circuit, adder logic or counter logic is used to collect statistics on the input data, a logic gate circuit is used to determine a statistical result to obtain a DBI signal, and then data is output based on the DBI signal.

However, in a determining process of the DBI circuit, a large quantity of adder circuits and logic gate circuits need to be used, resulting in a large area of the entire circuit. In addition, because an input digital signal needs to pass through an adder and a logic gate to obtain an output signal, a signal pathway is long, and input/output latency is long. Further, signal jumping in the gate circuit causes an increase in a current and generates large power consumption.

Therefore, how to optimize a structure of the DBI circuit and reduce the area, latency, and power consumption of the DBI circuit become an urgent problem to be resolved.

### SUMMARY

Embodiments of this application provide a data bus inversion determining method, to reduce an area, costs, and power consumption of a data bus inversion circuit.

According to a first aspect, a data bus inversion determining method is provided. The method includes: receiving N first input signals, where N is a positive integer; obtaining N first voltage signals based on the N first input signals, where the N first voltage signals are in one-to-one correspondence with the N first input signals; determining an average voltage value of the N first voltage signals; and determining, based on the average voltage value, whether to invert N second input signals, where the N first input signals are the same as the N second input signals, or the N first input signals are obtained based on the N second input signals.

In the solution provided in this application, directly solving an average voltage value of N voltage signals is equivalent to solving a sum of voltage values of the N voltage signals in a conventional method. The average voltage value of the N voltage signals is then determined, and a determining result is used to determine whether to perform inversion and outputting. In the conventional technology, an adder needs to be used to solve a sum of voltage values. A quantity of input bits of the adder is limited. If a value of N is large, a large quantity of adder circuits need to be used. However, because a structure of the adder circuit is complex, and a large quantity of elements need to be used, an area, transmission latency, and power consumption of the circuit are large. In this application, the average voltage value is solved. This avoids use of a large quantity of adder circuits and logic circuits, and greatly reduces an area, latency, and power consumption of the circuit.

In a possible implementation, that the N first input signals are obtained based on the N second input signals includes: The N first input signals are a result of comparison between the N second input signals and N signals that are output last time by a data bus inversion circuit.

For example, the N signals that are output last time by the data bus inversion circuit are stored in a register, and are compared with the N second input signals. If the signal that is output last time is the same as the second input signal, the first input signal is a first value; or if the signal that is output last time is different from the second input signal, the first input signal is a second value. The N first input signals are obtained based on the result of comparison.

In a possible implementation, the determining an average voltage value of the N first voltage signals includes: inputting the N first voltage signals respectively to N input ports of a first circuit, and determining, as the average voltage value, a voltage value of a voltage signal output from an output port of the first circuit, where the first circuit includes N branches, the N input ports are in one-to-one correspondence with the N branches, one end of each branch is connected to a corresponding input port, another end of each branch is connected to the output port, each branch includes a capacitor assembly, and capacitance values of capacitor assemblies of the branches are the same.

In a possible implementation, the determining, based on the average voltage value, whether to perform inversion includes: if the average voltage value is greater than a preset first threshold, determining to perform the inversion; or if the average voltage value is less than or equal to a first threshold, determining not to perform the inversion.

In this application, the average voltage value and the first threshold are in a same voltage domain. Therefore, comparison and determining need to be performed only once. In comparison with the conventional technology in which a result can only be obtained by comparing and determining the sum of the voltage values for a plurality of times, the solution in this application greatly reduces the area, latency, and power consumption of the circuit.

In a possible implementation, the method further includes: generating a control signal based on a determining result; and sending the control signal to an inversion processing circuit, where the control signal indicates the inversion processing circuit to invert a signal.

According to a second aspect, a data bus inversion circuit is provided, including: a conversion circuit, including a digital-to-analog converter, and configured to: receive N first input signals, and convert the N first input signals into N first voltage signals, where the N first voltage signals are in one-to-one correspondence with the N first input signals; a calculation circuit, including a capacitor component, where the calculation circuit is connected to the conversion circuit, and is configured to calculate an average voltage value of the N first voltage signals; and a determining circuit, including a comparing component, where the determining circuit is connected to the calculation circuit, and is configured to obtain a control signal based on the average voltage value.

In a possible implementation, the calculation circuit includes: a first circuit, where the first circuit includes N branches, one end of each branch is connected to a corresponding input port, another end of each branch is connected to an output port, each branch includes a capacitor assembly, capacitance values of capacitor assemblies of the branches are the same, the input port is electrically connected to the conversion circuit, and the output port is electrically connected to the determining circuit.

In a possible implementation, the determining circuit includes: a comparator, where a first threshold is set in the comparator; an input to the comparator is the average voltage value, and an output is the control signal; and if the average voltage value is greater than the first threshold, the control signal is a first value, or if the average voltage value is not greater than the first threshold, the control signal is a second value.

In a possible implementation, the determining circuit includes: an inversion processing circuit, configured to obtain an output signal based on the control signal.

In a possible implementation, the inversion processing circuit includes: an input conversion circuit, including a digital-to-analog converter, and configured to: receive the control signal and N second input signals, and convert the N second input signals into N second voltage signals, where the N second voltage signals are in one-to-one correspondence with the N second input signals; a processing circuit, including a logic circuit including a transistor, and configured to process the N second voltage signals based on the control signal to obtain N third voltage signals, where the processing circuit is connected to the input conversion circuit; and an output conversion circuit, including an analog-to-digital converter, and configured to: receive the N third voltage signals, convert the N third voltage signals into N output signals, and output the N output signals, where the N output signals are in one-to-one correspondence with the N third voltage signals, the output conversion circuit is connected to the processing circuit, and the second input signal is the same as or opposite to the output signal.

Optionally, the second input signal is the same as the first input signal.

Optionally, the first input signal is a result of comparison between the second input signal and a third input signal, and the third input signal is an input signal in a previous beat of the second input signal. For example, if the second input signal is the same as the third input signal, a voltage value corresponding to the first input signal is a high voltage; or if the second input signal is different from the third input signal, a voltage value corresponding to the first input signal is a low voltage.

The foregoing logic circuit has a plurality of implementations, provided that a required logic relationship is implemented. Different types, such as an XOR gate logic circuit and an AND-OR gate logic circuit, may be selected for the foregoing logic circuit based on an actual requirement.

In a possible implementation, processing the second input signal includes: if the control signal is the first value, inverting and then outputting the second input signal; or if the control signal is the second value, directly outputting the second input signal.

According to a third aspect, an electronic device is provided. The electronic device is provided with the circuit configured to perform data bus inversion according to the second aspect or any one of the second aspect.

### BRIEF DESCRIPTION OF DRAWINGS

FIG. 1 is a diagram of an application scenario according to an embodiment of this application;
FIG. 2 is a schematic flowchart of a DBI determining circuit according to an embodiment of this application;
FIG. 3 is a schematic flowchart of a DBI execution circuit according to an embodiment of this application;
FIG. 4 is a circuit schematic of a DBI determining circuit according to an embodiment of this application;
FIG. 5 is a circuit diagram of a DBI circuit according to an embodiment of this application;
FIG. 6 is a schematic of a structure of a DBI circuit according to an embodiment of this application;
FIG. 7 is a schematic of a structure of a NOT gate logic circuit according to an embodiment of this application;
FIG. 8 is a schematic of a structure of a NAND gate logic circuit according to an embodiment of this application;
FIG. 9 is a schematic of a structure of an AND gate logic circuit according to an embodiment of this application; and
FIG. 10 is a circuit schematic of an XOR gate logic circuit according to an embodiment of this application.

### DESCRIPTION OF EMBODIMENTS

The following describes technical solutions in embodiments of this application with reference to accompanying drawings.

Embodiments of this application provide a data bus inversion (Data Bus Inversion, DBI) determining method, a circuit, and an electronic device.

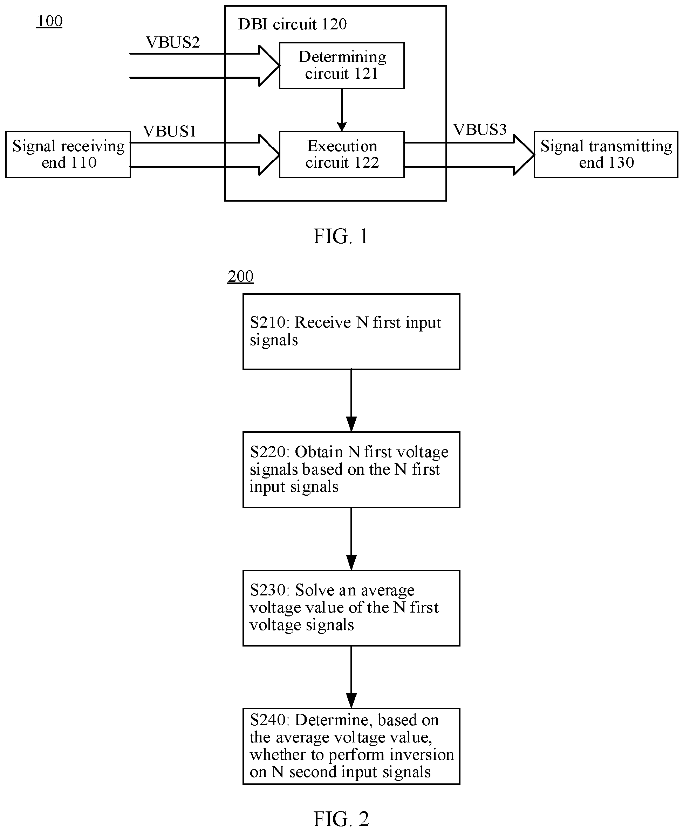

FIG. 1 is a diagram of an application scenario according to an embodiment of this application. This application may be applied to any electronic product that requires a data bus inversion function. As shown in FIG. 1, an electronic device 100 includes a signal receiving end 110, a DBI circuit 120, and a signal transmitting end 130. The DBI circuit includes a determining circuit 121 and an execution circuit 122. The determining circuit 121 and the execution circuit 122 are connected through a conducting wire 123.

The signal receiving end 110 is configured to: receive an external signal, and output N voltage signals. The signal transmitting end is configured to: receive N voltage signals sent by the DBI circuit, and send a processed external signal, where N is a positive integer.

It should be noted that voltage values of the N voltage signals in this application are a first voltage value and a second voltage value. The first voltage value and the second voltage value are in a same voltage domain, and the first voltage value is greater than the second voltage value.

It should be understood that the external signal received by the signal receiving end and the external signal sent by the signal transmitting end are not limited to a voltage signal. In other words, the signal receiving end and the signal transmitting end include a signal processing unit. Conversion of a signal type is a common technical means in the field, and does not affect an inventive point of this application. Details are not described in this application.

The determining circuit 121 receives N first voltage signals through an input voltage port VBUS2, and outputs a control signal to the execution circuit 122 through the conducting wire 123.

The execution circuit 122 receives the control signal from the determining circuit 121 through the conducting wire 123, receives, through an input voltage port VBUS 1, N second voltage signals sent by the signal receiving end 110, and sends N output voltage signals to the signal transmitting end 130 through an output voltage port VBUS3. The output voltage signal is obtained by processing the second voltage signal by the execution circuit 122.

In an implementation, the first voltage signal input to the determining circuit 121 in the DBI circuit 120 is the second voltage signal sent by the signal receiving end 110. The determining circuit 121 determines whether a quantity of second voltage values in the first voltage signals exceeds a threshold to obtain the control signal, and the execution circuit 122 outputs the N output voltage signals based on the control signal.

Specifically, if the determining circuit 121 determines that the quantity of second voltage values in the received N first voltage signals exceeds the threshold, the output control signal is the first voltage value, and the execution circuit 122 inverts and outputs the N second voltage signals; or if the determining circuit 121 determines that the quantity of second voltage values in the received N first voltage signals does not exceed the threshold, the output control signal is the second voltage value, and the execution circuit 122 directly outputs the N second voltage signals.

Specifically, that the execution circuit 122 inverts and outputs the N second voltage signals means that if a voltage value of the second voltage signal is the first voltage value, a corresponding output voltage value is the second voltage value; or if a voltage value of the second voltage signal is the second voltage value, a corresponding output voltage value is the first voltage value.

In another implementation, an input to the determining circuit 121 in the DBI circuit 120 is a result of comparison between the N second voltage signals sent by the signal receiving end 110 and N third voltage signals, and the third voltage signal is a voltage signal sent last time by the signal receiving end 110. The result of comparison is N voltage signals obtained by comparing the N second voltage signals one by one with the N third voltage signals sent last time. For example, if voltage values are the same, the result of comparison is the first voltage value; or if voltage values are different, the result of comparison is the second voltage value. The DBI circuit 120 determines whether a quantity of second voltage values in the result of comparison exceeds a threshold, and outputs data based on a determining result.

Specifically, if the determining circuit 121 determines that the quantity of second voltage values in the received N voltage signals exceeds the threshold, the output control signal is the first voltage value, and the execution circuit 122 inverts and outputs the N second voltage signals; or if the determining circuit 121 determines that the quantity of second voltage values in the received N second voltage signals does not exceed the threshold, the output control signal is the second voltage value, and the execution circuit 122 directly outputs the N second voltage signals.

It should be understood that a relationship between the control signal and the output in this embodiment is merely an example. Actually, a correspondence between the control signal and the output is not limited in this application.

For example, the input voltage port may be a USB port, and the USB port may support a plurality of standards, for example, a Type C standard, a micro (micro) USB standard, and a mini (mini) USB standard.

For example, the electronic device 100 may be a mobile phone, a tablet computer, a handheld electronic device, an intelligent terminal, or another type of electronic device.

FIG. 2 is a schematic flowchart of a DBI determining circuit. It should be noted that, in the schematic, a value of a voltage signal is a first voltage value or a second voltage value, and the first voltage value is greater than the second voltage value. Details are shown in FIG. 2:

S210: The DBI determining circuit receives N first input signals in parallel, where the DBI determining circuit includes N parallel branches, and one voltage signal of N voltage signals is input to each branch.

S220: The DBI determining circuit obtains N first voltage signals based on the N first input signals, where the DBI determining circuit includes a digital-to-analog conversion apparatus.

S230: The DBI determining circuit solves an average voltage value of the N first voltage signals, where the average voltage value is a value obtained by dividing a sum of voltage values of the N voltage signals by a quantity N of voltage signals, and the average voltage value is neither higher than the first voltage value nor lower than the second voltage value.

In an implementation, a calculation module has N parallel branches, each branch includes capacitors with an equal capacitance value, an input to the capacitor on each branch corresponds to a voltage signal in the N voltage signals, and an output of the capacitor on each branch is connected to a voltage node. A voltage value of the voltage node is the average voltage value.

S240: The DBI determining circuit determines, based on the average voltage value, whether to invert N second input signals, where the N first input signals are the same as the N second input signals, or the N first input signals are obtained based on the N second input signals.

For example, N signals that are output last time by a data bus inversion circuit are stored in a register, and are compared with the N second input signals. If the signal that is output last time is the same as the second input signal, the first input signal is a first value; or if the signal that is output last time is different from the second input signal, the first input signal is a second value. The N first input signals are obtained based on a result of comparison.

In an implementation, the DBI determining circuit outputs a control signal based on a determining result. If the average voltage value is greater than a threshold, the control signal is the first voltage value; or if the average voltage value is not greater than a threshold, the control signal is the second voltage value.

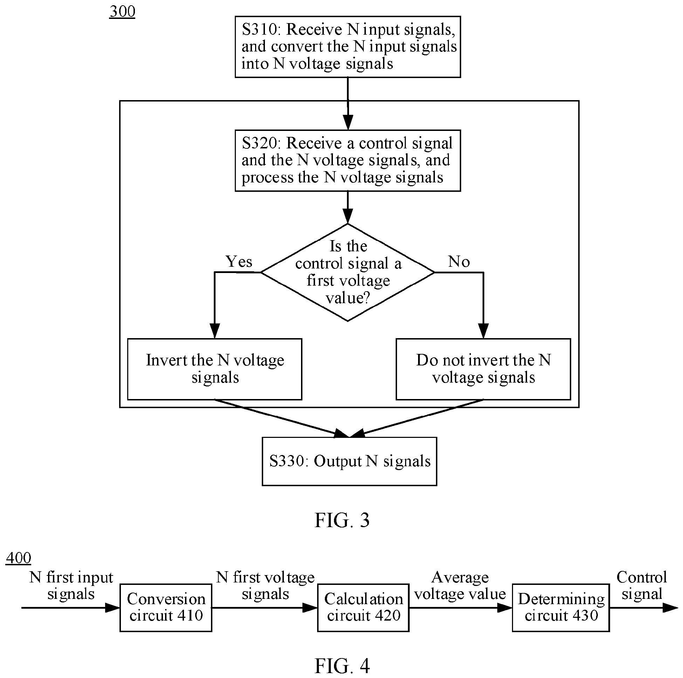

FIG. 3 is a schematic flowchart of a DBI processing circuit. It should be noted that, in the schematic, a value of a control signal is a first voltage value or a second voltage value, and the first voltage value is greater than the second voltage value. As shown in FIG. 3:

S310: The DBI processing circuit receives N input signals, and converts the N input signals into N voltage signals, where the DBI processing circuit includes a digital-to-analog converter.

In an implementation, the DBI processing circuit further includes a switch component. When the switch component is turned off, the DBI processing circuit does not send the control signal. When the switch component is turned on, an input unit of a DBI execution circuit sends the control signal. It should be understood that the switch component is merely an example, and any component having a same function may be used. This is not limited in this application.

S320: The DBI processing circuit receives the control signal and the N voltage signals, and processes the N voltage signals.

In an implementation, if the received control signal is the first voltage value, the DBI processing circuit inverts the N voltage signals, that is, changes the first voltage value in the N voltage signals to the second voltage value, or changes the second voltage value to the first voltage value. If the received control signal is the second voltage value, the DBI processing circuit does not change the N voltage signals.

S330: The DBI processing circuit outputs N signals, where the N signals are in one-to-one correspondence with processed N voltage signals, and the DBI processing circuit includes an analog-to-digital converter.

FIG. 4 is a circuit schematic of a DBI determining circuit according to an embodiment of this application. As shown in FIG. 4, the DBI determining circuit 400 includes a conversion circuit 410, a calculation circuit 420, and a determining circuit 430.

The conversion circuit 410 receives N first input signals, and outputs N first voltage signals to the calculation circuit 420.

In an implementation, the conversion circuit 410 includes a digital-to-analog converter that converts the first input signal into the first voltage signal.

The calculation circuit 420 receives the N first voltage signals, and outputs an average voltage value of the N first voltage signals to the determining circuit.

In an implementation, the calculation circuit 420 includes N parallel branches, an input to each branch corresponds to a first voltage signal, outputs are connected to a same voltage node, and a voltage value of the voltage node is an average value of voltage values of voltage signals in a first voltage signal group. Each branch further includes one or more capacitor components, and the average voltage value is solved through charge conservation of a capacitor.

The determining circuit 430 receives the average voltage value, and obtains a control signal based on the average voltage value.

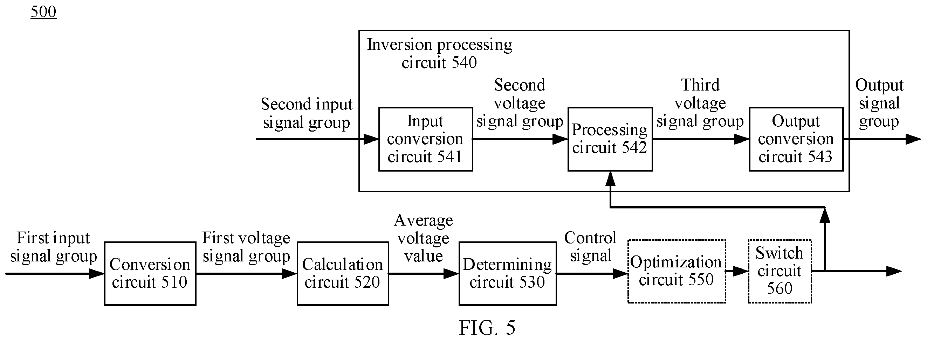

In an implementation, the determining circuit 430 includes a comparator, and a first threshold is set in the comparator. If the average voltage value is greater than the first threshold, the control signal is a first value; or if the average voltage value is not greater than the first threshold, the control signal is a second value. FIG. 5 is a schematic of a DBI circuit according to an embodiment of this application. As shown in FIG. 5, the circuit is configured to determine output data based on a quantity of bits of a high voltage in input N-bit digital data or a quantity of bits of input N-bit digital data that is different from a previous beat of data. For ease of understanding, the following describes a basic principle of the DBI circuit with reference to FIG. 5.

As shown in FIG. 5, the DBI circuit 500 includes a conversion circuit 510, a calculation circuit 520, a determining circuit 530, and an inversion processing circuit 540.

Inputs to the DBI circuit 500 are a first input signal group and a second input signal group. The first input signal group is used as an input to the conversion circuit 510, and the second input signal group is used as an input to the inversion processing circuit. A first voltage signal group is obtained after the first input signal group passes through the conversion circuit 510. The first input signal group includes N input signals, the first voltage signal group includes N parallel voltage signals, a value of the voltage signal is a first voltage value or a second voltage value, and the first voltage value is greater than the second voltage value.

In an implementation, the first input signal group is the same as the second input signal group. In this case, the DBI circuit is configured to ensure that a quantity of first voltage values in N output voltage signals exceeds a threshold.

In another implementation, the first input signal group is a result of comparison between the second input signal group and a signal group output last time. In this case, the DBI circuit is configured to ensure that a quantity of changed signals in an output signal group compared with the signal group output last time does not exceed a threshold.

The calculation circuit 520 receives the first voltage signal group, and outputs an average voltage value of voltage values of the voltage signals in the first voltage signal group.

In an implementation, the calculation circuit 520 receives the first voltage signal group through N parallel branches, where an input to each branch is a voltage value of a voltage signal in the first voltage signal group, and outputs are a same voltage node. A voltage value of the output voltage node is an average value of the voltage values of the voltage signals in the first voltage signal group.

Each parallel branch of the calculation circuit 520 has a capacitor unit. One end of the capacitor unit is connected to a voltage value of a voltage signal in the first voltage signal group, and another end of each capacitor unit is connected to an average voltage node. Capacitance values of all the capacitor units are the same, and each capacitor unit includes one or more capacitor components.

The calculation circuit 520 adds the voltage values of the voltage signals in the first voltage signal group and divides a sum by a quantity N of data bits by using a charge conservation principle, to obtain the average voltage value, and transmits the average voltage value to the determining circuit 530. The average voltage value does not exceed the first voltage value, and is not lower than the second voltage value.

The charge conservation principle means that for an isolated system, no matter what changes, an algebraic sum of all charges always remains unchanged. The charge conservation principle shows that if a quantity of charges in a region increases or decreases, there is definitely an equal quantity of charges entering or leaving the region. If a charge is generated or disappears in a physical process, there is definitely an equal quantity of opposite charges generated or disappearing at the same time.

The calculation circuit 520 uses the charge conservation principle of a capacitor to calculate the average voltage value. In the calculation circuit 520, if a quantity of charges at one end of the capacitor unit increases, a same quantity of charges at another end of the capacitor unit definitely decreases, and a total quantity of charges at two ends of the capacitor unit remains unchanged. A quantity of charges in the capacitor unit is represented as a product of a voltage and a capacitance value. Because the capacitance values of the capacitor units in all the branches in this application are the same, it may be directly converted into that in an entire circuit system, algebraic sums of total voltage values at two ends of the capacitor units are equal. A voltage value at one end of the capacitor unit is a voltage value of the input voltage signal. In the entire circuit system, an algebraic sum of total voltage values corresponding to the N branches is a sum of the voltage values of the voltage signals in the first voltage signal group. Because another end of each capacitor unit is connected to one node, a voltage value of another end of the capacitor unit of each branch is equal, and the total voltage value is equal to the voltage value of another end of the capacitor unit multiplied by N. In addition, because the algebraic sum of the total voltage values at other ends of the capacitor units is equal to the sum of the voltage values of the voltage signals in the first voltage signal group, the voltage value at another end of the capacitor unit is equal to the sum of the voltage values of the voltage signals in the first voltage signal group divided by N. Therefore, the calculation unit outputs the average voltage value.

For example, the capacitor unit in the calculation circuit 520 may be a capacitor and/or a transistor that acts as a capacitor.

The determining circuit 530 receives the average voltage value, compares the average voltage value with a set threshold, and outputs a result of comparison to obtain a control signal, where a value of the control signal is the first voltage value or the second voltage value, and the first voltage value is greater than the second voltage value.

The threshold set in the determining circuit 530 may be adjusted based on different actual requirements. For example, if an objective of the DBI circuit is that a quantity of first voltage values in an output voltage signal group is more than a half, the threshold may be half of a sum of the first voltage value and the second voltage value.

In an implementation, the determining circuit 530 includes an operational amplifier. If the input average voltage value is greater than the threshold, the control signal is the first voltage value. If the input average voltage value is not greater than the threshold, the control signal is the second voltage value.

In another implementation, the determining circuit 530 includes a phase inverter. If the input average voltage value is greater than the threshold, the control signal is the second voltage value. If the input average voltage value is not greater than the threshold, the control signal is the first voltage value.

Optionally, the DBI circuit further includes an optimization circuit 550. The optimization circuit 550 receives and processes the control signal output by the determining circuit 530, where a processing manner includes amplification and/or phase inversion; and then outputs the control signal.

Optionally, the DBI circuit further includes a switch circuit 560. An input to the switch circuit 560 is the control signal that is output by the determining circuit 530 or the optimization circuit 550 and an external control signal. Whether the DBI circuit can work normally is determined based on the external control signal.

In an implementation, the switch circuit 560 is an AND gate logic circuit. Inputs to the logic circuit are an enable signal and the control signal, and an output is an input to a processing circuit 542. If the enable signal is the second voltage value, the DBI circuit does not work. In this case, output data is a second voltage signal group. If the enable signal is the first voltage value, the DBI circuit works normally.

The inversion processing circuit 540 includes an input conversion circuit 541, the processing circuit 542, and an output conversion circuit 543. The inversion processing circuit 540 receives the second input signal group, and obtains the second voltage signal group through the input conversion circuit 541. The second input signal group includes N input signals, the second voltage signal group includes N parallel voltage signals, a value of the voltage signal is a first voltage value or a second voltage value, and the first voltage value is greater than the second voltage value.

In an implementation, the input conversion circuit 541 and the conversion circuit 510 are a same circuit.

The processing circuit 542 receives and processes the second voltage signal group and the control signal, and then outputs a third voltage signal group to the output conversion circuit 543.

In an implementation, the processing circuit 542 is a NOR gate logic circuit, and inputs to the NOR gate logic circuit are the second voltage signal group and the control signal. When the control signal is the first voltage value, the third voltage signal group output by the NOR gate logic circuit is a result obtained by inverting the second voltage signal group. When the control signal is the second voltage value, the third voltage signal group output by the NOR gate logic circuit is the same as the second voltage signal group.

The output conversion circuit 543 converts the third voltage signal group to obtain an output signal group, and outputs the output signal group.

In this application, the average voltage value of input data is solved by using the capacitor and the charge conservation principle, digital data is converted into analog data, analog-to-digital conversion is performed on the average voltage value by using a comparator, and the control signal is determined. In comparison with the conventional technology in which a large quantity of full adders are used for solving a sum of input data, in this application, a simulation method is used to replace conventional adder logic, to implement a DBI function. This greatly reduces use of a logic gate circuit, reduces an area of a chip, reduces latency from inputting the control signal to outputting the control signal, and reduces current consumption of the DBI circuit.

It should be noted that the logic circuit may be implemented by using the transistor.

The transistor is a single element based on semiconductor materials, including a diode (two terminals), a triode, a field effect transistor, and a thyristor (the last three all have three terminals) made of various semiconductor materials. The field effect transistor is most widely used.

A metal-oxide-semiconductor field effect transistor (Metal-Oxide-Semiconductor Field Effect Transistor, MOSFET) is a field effect transistor that can be widely used in an analog circuit and a digital circuit. MOSFETs may be classified into two types: an "N-type" and a "P-type", that is, an N-type metal-oxide-semiconductor (Negative-channel Metal Oxide Semiconductor, NMOS) and a P-type metal-oxide-semiconductor (Positive-channel Metal Oxide Semiconductor, PMOS) based on different polarities of their "channels" (working carriers).

When the transistor is implemented through the MOSFET, a first end and a second end of the transistor may respectively be a source end and a drain end of the MOSFET.

For ease of description, in this application, when the MOSFET is the NMOS, the first end is the drain end, and the second end is the source end. When the MOSFET is the PMOS, the first end is the source end, and the second end is the drain end.

When the transistor is implemented through the triode, a first end and a second end of the transistor may respectively be an emitting electrode and a collecting electrode of the triode. For example, when the triode is an NPN-type transistor, the first end may be the collecting electrode, and the second end may be the emitting electrode. When the triode is a PNP-type transistor, the first end may be the emitting electrode, and the second end may be the collecting electrode.

In addition, for ease of description, the MOSFET is selected as a transistor to construct a logic circuit. Selection of a transistor for constructing the logic circuit is not limited in this application.

It should be understood that an implementation of the logic circuit in this application is merely an example, and the logic circuit may further include another implementation.

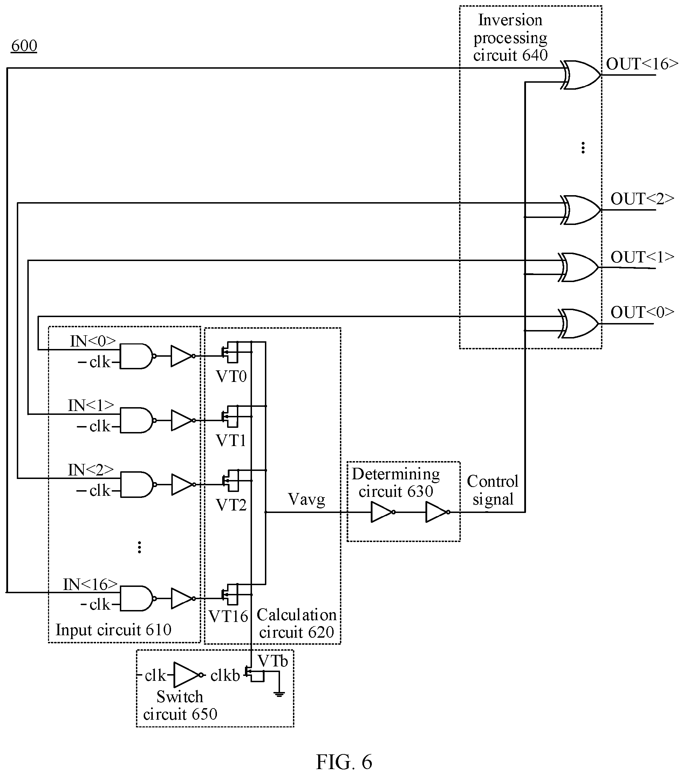

FIG. 6 is a specific circuit schematic of a DBI circuit according to an embodiment of this application.

It should be understood that, in this embodiment, for ease of description, 17 bits are selected for input. However, a quantity of bits of input data is not limited in this application.

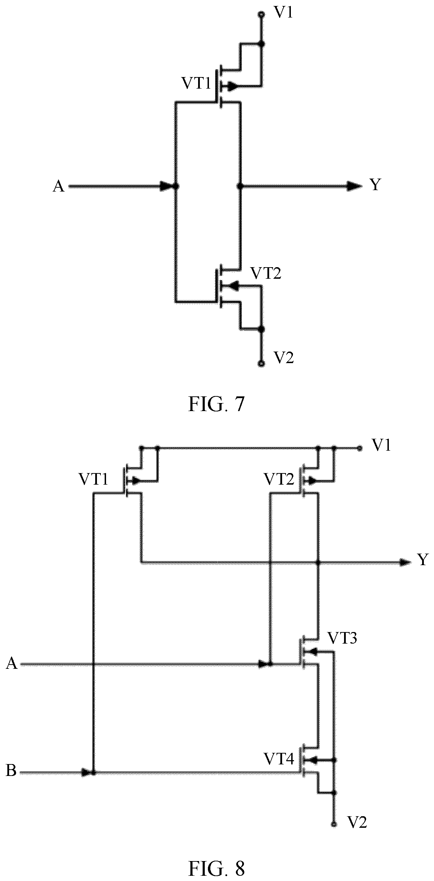

It should be understood that circuit composition of a logic gate circuit in this embodiment is described in FIG. 7 to FIG. 10. In this embodiment, a logic circuit symbol is used merely for representation, and a specific logic circuit structure is not described in detail.

It should be understood that the circuit in FIG. 6 further includes a digital-to-analog converter and an analog-to-digital converter. Signal conversion is a common technical means in the field and is not specifically drawn in the figure. Both an input signal and an output signal in the figure are already converted.

As shown in FIG. 6, the DBI circuit 600 includes an input circuit 610, a calculation circuit 620, a determining circuit 630, and an inversion processing circuit 640. In an implementation, the DBI circuit 600 further includes a switch circuit 650. It should be understood that, in FIG. 6, the input circuit 610 further includes the digital-to-analog converter, and the inversion processing circuit 640 further includes the analog-to-digital converter. These are not specifically drawn in the figure.

IN<16:0> represents 17 input voltage signals. VT0 to VT16 represent 17 transistors for calculating an average voltage value. VTb represents an NMOS used as a switch. Vavg represents a calculated average voltage value. clk and clkb represent clock signals.

The clock signal clk and an input voltage signal group IN<16:0> are used as two inputs to an AND gate logic circuit. After passing through the AND gate logic circuit, the clock signal clk and the input voltage signal group IN<16:0> are connected together through VT<16: 0> to constitute an average voltage Vavg node, to obtain the average voltage value. The clock signal is for ensuring that voltage signals in the input voltage group can be input at the same time.

The AND gate logic circuit includes a NAND gate logic circuit and a reverse circuit. It should be understood that the reverse circuit may include an odd-number quantity of NOT gate logic circuits.

A reference voltage of a comparator is compared with the average voltage value, and amplification is performed, to obtain that the average voltage value is greater than a threshold or less than a threshold, to obtain a corresponding control signal.

In this embodiment of this application, the comparator includes the NOT gate logic circuit. For ease of description, a comparator having a two-stage NOT gate logic circuit is drawn in the figure. If the average voltage value is greater than the threshold, the comparator outputs a first voltage value; or if the average voltage value is not greater than the threshold, the comparator outputs a second voltage value.

It should be noted that a quantity of stages of the NOT gate logic circuit in the comparator is not limited in this application. If a NOT gate logic circuit having an odd-number quantity of stages is used, the circuit performs inversion when the average voltage value is less than the threshold. If an NOT gate logic circuit having an even-number quantity of stages is used, the circuit performs inversion when the average voltage value is greater than the threshold. A structure of the NOT gate logic circuit is simple. This can further reduce an area of the circuit.

The threshold may be set based on an actual requirement by adjusting quantities of PMOSs and NMOSs that constitute the NOT gate logic circuit.

For example, if an objective of the DBI circuit is that a quantity of first voltage values in an output voltage signal group is more than a half, the threshold may be half of a sum of the first voltage value and the second voltage value.

For example, the comparator may be an operational amplifier, and the average voltage value is compared with the threshold through the operational amplifier. If the average voltage value is greater than the threshold, the operational amplifier outputs the first voltage value; or if the average voltage value is not greater than the threshold, the operational amplifier outputs the second voltage value.

The obtained control signal and the input voltage signal group IN<16:0> are used as two inputs to an XOR gate logic circuit to obtain an output result OUT<16:0>. According to a characteristic of the XOR gate logic circuit, if the input control signal is the first voltage value, an output result is a voltage signal group obtained by inverting IN<16:0>. If the input control signal is the second voltage value, an output result is IN<16:0>.

In this embodiment, the average voltage value is obtained by simulating even distribution of voltages by using a charge conservation principle at two ends of a capacitor. A manufacturing process of a conventional capacitor is complex, precision is poor and an area is large. In this embodiment of this application, NMOS transistors VT0 to VT16 are used as equivalent capacitors. In a structure of the MOSFET, a metal-oxide-semiconductor capacitor is used as a core. A material of an oxide layer is mostly silicon dioxide, below which is silicon used for a base electrode, and above which is polycrystalline silicon used for a gate electrode. This can meet a requirement of serving as the equivalent capacitor. One side of the equivalent capacitor is a gate end of the MOSFET, and another side is a source end, a drain end, and a substrate end of the MOSFET that are short-circuited. Use of the transistor equivalent capacitor can ensure precision, facilitate accuracy of threshold determining, and further reduce the area of the circuit.

In this embodiment, the NMOS transistor is further used as the switch of the circuit. After the clock signal clk passes through the NOT gate logic circuit, clkb is input to the NMOS transistor VTb to control turn-on and turn-off of VTb. When clk = 0, the NMOS transistor VTb is turned on, Vavg is pulled down to an electrical potential 0, and gate ends of the transistors VT0 to VT16 are controlled by AND gate logic of clk and are at an electrical potential 0. Therefore, the electrical potentials at two ends of the equivalent capacitors VT0 to VT16 are 0. When clk = 1, the NMOS transistor VTb is turned off, and an input on one side of the equivalent capacitors VT0 to VT16 is a voltage value of IN<16:0>, outputs on other sides are connected in parallel to a same voltage node. The average voltage value Vavg is calculated by using the charge conservation principle at two ends of the capacitor.

When the transistor is used as the switch, turning on the switch means that a control end (for example, a gate electrode) of the switch controls two ends (for example, a source electrode and a drain electrode) of the switch to be turned on. Turning off the switch means that the control end (for example, the gate electrode) of the switch controls two ends (for example, the source electrode and the drain electrode) of the switch to be turned off, that is, the two ends of the switch does not conduct or almost does not conduct a current.

It should be noted that when the MOSFET is used as the switch, the source end and the drain end may be considered as a same terminal and are interchangeable.

Embodiments of this application relate to various logic circuits. The following provides embodiments of the logic circuits in this application. It should be understood that logic gate circuits having a same logic function have a plurality of different specific implementations, and a person skilled in the art can easily implement corresponding logic gate circuits through proper components. The following embodiments are merely examples, and do not limit a logic circuit in this application.

FIG. 7 is a schematic of a structure of a NOT gate logic circuit according to an embodiment of this application. The NOT gate logic circuit is also referred to as a phase inverter, and is a basic unit of a logic circuit. A NOT gate has an input end and an output end. When the input end is a first voltage value V1 (logic 1), the output end is a second voltage value V2 (logic 0). When the input end is a second voltage value, the output end is a first voltage value.

As shown in FIG. 7, the NOT gate logic circuit includes a pair of MOSFETs. VT1 is a PMOS. VT2 is an NMOS. A second end of VT1 is connected to a first end of VT2. A voltage V1 at a first end of VT1 is the first voltage value, and a voltage V2 at a second end of VT2 is the second voltage value. When an input A is the second voltage value, VT1 is turned on, VT2 is turned off, and an output Y is the first voltage value. When an input A is the first voltage value, VT1 is turned off, VT2 is turned on, and an output Y is the second voltage value.

FIG. 8 is a schematic of a structure of a NAND gate logic circuit according to an embodiment of this application. The NAND gate logic circuit is a basic logic circuit of a digital circuit, and has a plurality of inputs and an output. If all of the inputs are a first voltage value V1 (logic 1), the output is a second voltage value V2 (logic 0). If at least one of the inputs is a second voltage value, the output is a first voltage value.

As shown in FIG. 8, the NAND gate logic circuit includes two NMOSs and two PMOSs. VT1 and VT2 are PMOSs. VT3 and VT4 are NMOSs. VT1 is connected to a first end of VT2. A second end of VT3 is connected to a second end and a first end of VT4. A first end of VT3 is connected to a second end of VT1 and a second end of VT2. V1 is the first voltage value, and V2 is the second voltage value. When inputs A and B are both first voltage values, VT1 and VT2 are turned off, VT3 and VT4 are turned on, and an output Y is the second voltage value. When inputs A and B are both second voltage values, VT1 and VT2 are turned on, VT3 and VT4 are turned off, and an output Y is the first voltage value. When an input A is the first voltage value and an input B is the second voltage value, VT1 and VT3 are turned on, VT2 and VT4 are turned off, and an output Y is the first voltage value. When an input A is the second voltage value and an input B is the first voltage value, VT1 and VT3 are turned off, VT2 and VT4 are turned on, and an output Y is the first voltage value.

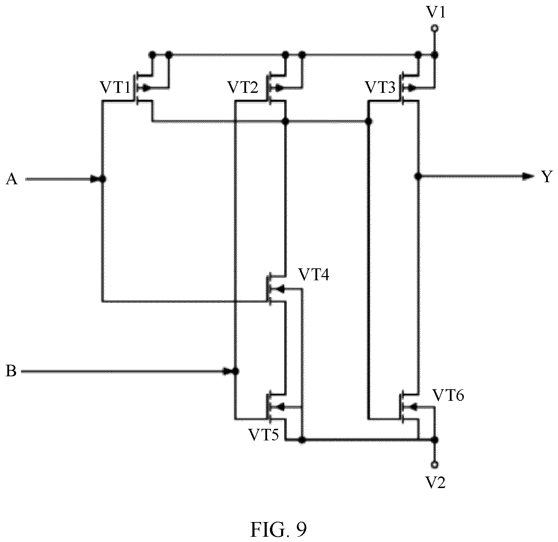

FIG. 9 is a schematic of a structure of an AND gate logic circuit according to an embodiment of this application. The AND gate logic circuit is a basic logic gate circuit that performs an "AND" operation, and has a plurality of input ends and an output end. When all inputs are a first voltage value V1 (logic 1), an output is the first voltage value. When not all inputs are a first voltage value V1 (logic 1), an output is a second voltage value V2 (logic 0).

As shown in FIG. 9, the AND gate logic circuit may be considered as a combination of a NAND gate logic circuit and a NOT gate logic circuit. VT1, VT2, VT4, and VT5 constitute the NAND gate logic circuit. VT3 and VT6 constitute the NOT gate logic circuit. VT1, VT2, and VT3 are PMOSs. VT4, VT5, and VT6 are NMOSs. A second end of VT2 is connected to a second end of VT3, so that an output of the NAND gate logic circuit becomes an input to the NOT gate logic circuit. When inputs A and B are both first voltage values, VT1, VT2, and VT6 are turned off, VT3, VT4, and VT5 are turned on, and an output Y is the first voltage value. When inputs A and B are both second voltage values, VT1, VT2, and VT3 are turned on, VT4, VT5, and VT6 are turned off, and an output Y is the second voltage value. When an input A is the first voltage value and an input B is the second voltage value, VT1, VT3, and VT4 are turned on, VT2, VT5, and VT6 are turned off, and an output Y is the second voltage value. When an input A is the second voltage value and an input B is the first voltage value, VT2, VT3, and VT5 are turned on, VT1, VT4, and VT6 are turned off, and an output Y is the second voltage value.

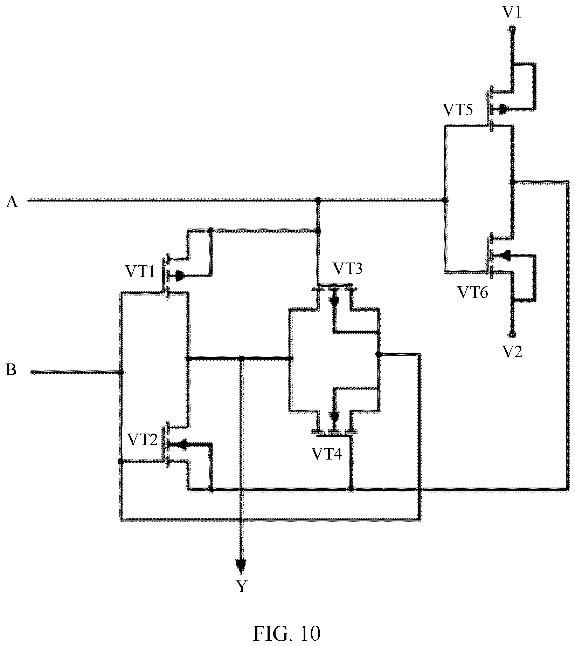

FIG. 10 is a schematic of a structure of an XOR gate logic circuit according to an embodiment of this application. The XOR gate logic circuit is a logic gate that implements XOR logic in digital logic, and has a plurality of input ends and an output end. A multi-input XOR gate may include two-input XOR gates. If voltages of two inputs are different, an output is a first voltage value V1 (logic 1). If voltages of two inputs are the same, an output is a second voltage value V2 (logic 0).

As shown in FIG. 10, the XOR gate logic circuit includes a plurality of NMOSs. VT1, VT3, and VT5 are PMOSs. VT2, VT4, and VT6 are NMOSs. A second end of VT1 is connected to a first end of VT2. A first end of VT3 is connected to a second end of VT4. A second end of VT3 is connected to a first end of VT4. A second end of VT5 is connected to a first end of VT6. When inputs A and B are both first voltage values, VT2 and VT6 are turned on, VT1, VT3, VT4, and VT5 are turned off, and an output Y is the second voltage value. When inputs A and B are both second voltage values, VT4 and VT5 are turned on, VT1, VT2, VT3, and VT6 are turned off, and an output Y is the second voltage value. When an input A is the first voltage value and an input B is the second voltage value, VT1 and VT6 are turned on, VT2 to VT5 are turned off, and an output Y is the first voltage value. When an input A is the second voltage value, and an input B is the first voltage value, VT2, VT3, VT4, and VT5 are turned on, VT1 and VT6 are turned off, and an output Y is the first voltage value.

A person of ordinary skill in the art may be aware that, with reference to the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes outside of the scope of this application.

A person skilled in the art may clearly understand that, for the purpose of convenient and brief description, for a detailed working process of the foregoing system, apparatus, and unit, refer to a corresponding process in the foregoing method embodiment. Details are not described herein again.

In several embodiments provided in this application, it should be understood that the disclosed system, apparatus, and method may be implemented in another manner. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electrical, mechanical, or other forms.

The units described as separate parts may be physically separated or not, and parts displayed as units may or may not be physical units, that is, may be located in one position, or may be distributed on a plurality of network units. A part or all of the units may be selected based on actual requirements to achieve the objectives of the solutions of embodiments.

In addition, functional units in embodiments of this application may be integrated into one processing unit, or each of the units may exist alone physically, or two or more units may be integrated into one unit.

When the functions are implemented in the form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, or a network device) to perform all or some of the steps of the methods described in embodiments of this application. The foregoing storage medium includes any medium that can store program code, such as a USB flash drive, a removable hard disk, a read-only memory (Read-Only Memory, ROM), a random access memory (Random Access Memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A data bus inversion determining method, comprising:
receiving N first input signals, wherein N is a positive integer;
obtaining N first voltage signals based on the N first input signals, wherein the N first voltage signals are in one-to-one correspondence with the N first input signals;
determining an average voltage value of the N first voltage signals; and
determining, based on the average voltage value, whether to invert N second input signals, wherein
the N first input signals are the same as the N second input signals, or the N first input signals are obtained based on the N second input signals.

2. The method according to claim 1, wherein that the N first input signals are obtained based on the N second input signals comprises:
the N first input signals are a result of comparison between the N second input signals and N signals that are output last time by a data bus inversion circuit.

3. The method according to claim 1 or 2, wherein the determining an average voltage value of the N first voltage signals comprises:
inputting the N first voltage signals respectively to N input ports of a first circuit, and determining, as the average voltage value, a voltage value of a voltage signal output from an output port of the first circuit, wherein the first circuit comprises N branches, the N input ports are in one-to-one correspondence with the N branches, one end of each branch is connected to a corresponding input port, another end of each branch is connected to the output port, each branch comprises a capacitor assembly, and capacitance values of capacitor assemblies of the branches are the same.

4. The method according to any one of claims 1 to 3, wherein the determining, based on the average voltage value, whether to perform inversion comprises:
if the average voltage value is greater than a preset first threshold, determining to perform the inversion; or
if the average voltage value is less than or equal to a first threshold, determining not to perform the inversion.

5. The method according to any one of claims 1 to 4, wherein the method further comprises:
generating a control signal based on a determining result; and
sending the control signal to an inversion processing circuit, wherein the control signal indicates the inversion processing circuit to invert a signal.

6. A data bus inversion circuit, comprising:
a conversion circuit, comprising a digital-to-analog converter, and configured to: receive N first input signals, and convert the N first input signals into N first voltage signals, wherein the N first voltage signals are in one-to-one correspondence with the N first input signals;
a calculation circuit, wherein the calculation circuit is connected to the conversion circuit, and is configured to calculate an average voltage value of the N first voltage signals; and
a determining circuit, wherein the determining circuit is connected to the calculation circuit, and is configured to obtain a control signal based on the average voltage value.

7. The circuit according to claim 6, wherein the calculation circuit comprises:
a capacitor component.

8. The circuit according to claim 6 or 7, wherein the determining circuit comprises:
a comparing component.

9. The circuit according to any one of claims 6 to 8, wherein the calculation circuit comprises:
a first circuit, wherein the first circuit comprises N branches, one end of each branch is electrically connected to a corresponding input port, another end of each branch is connected to an output port, each branch comprises a capacitor assembly, capacitance values of capacitor assemblies of the branches are the same, the input port is connected to the conversion circuit, and the output port is connected to the determining circuit.

10. The circuit according to any one of claims 6 to 9, wherein the determining circuit comprises:
a comparator, wherein a first threshold is set in the comparator;
an input to the comparator is the average voltage value, and an output is the control signal; and
if the average voltage value is greater than the first threshold, the control signal is a first value; or
if the average voltage value is not greater than the first threshold, the control signal is a second value.

11. The circuit according to any one of claims 6 to 10, further comprising:
an inversion processing circuit, configured to obtain an output signal based on the control signal.

12. The circuit according to claim 11, wherein the inversion processing circuit comprises:
an input conversion circuit, comprising a digital-to-analog converter, and configured to: receive the control signal and N second input signals, and convert the N second input signals into N second voltage signals, wherein the N second voltage signals are in one-to-one correspondence with the N second input signals;
a processing circuit, comprising a logic circuit including a transistor, and configured to process the N second voltage signals based on the control signal to obtain N third voltage signals, wherein the processing circuit is connected to the input conversion circuit; and
an output conversion circuit, comprising an analog-to-digital converter, and configured to: receive the N third voltage signals, convert the N third voltage signals into N output signals, and output the N output signals, wherein the N output signals are in one-to-one correspondence with the N third voltage signals, and the output conversion circuit is connected to the processing circuit.

13. The circuit according to claim 11 or 12, wherein processing the second input signal comprises:
if the control signal is the first value, inverting and then outputting the second input signal; or
if the control signal is the second value, directly outputting the second input signal.

14. An electronic device, comprising:
the circuit according to any one of claims 6 to 10; and/or
the circuit according to any one of claims 11 to 13.
